(19) **Europäisches Patentamt / European Patent Office / Office européen des brevets**

(11) **EP 2 063 464 B1**

(12) **EUROPEAN PATENT SPECIFICATION**

(45) Date of publication and mention of the grant of the patent:
**29.11.2017 Bulletin 2017/48**

(21) Application number: **09153586.4**

(22) Date of filing: **13.10.1998**

(51) Int Cl.:
*H01L 21/316* (2006.01) *H01L 21/311* (2006.01)
*H01L 21/28* (2006.01) *H01L 21/321* (2006.01)
*H01L 49/02* (2006.01)

(54) **Method for oxidizing a structure during the fabrication of a semiconductor device**

Verfahren zum Oxidieren einer Struktur während der Herstellung einer Halbleitervorrichtung

Méthode d'oxydation d'une structure durant la fabrication d'un dispositif semiconducteur

(84) Designated Contracting States:
**DE FR GB NL**

(30) Priority: **14.10.1997 US 61827 P**

(43) Date of publication of application:
**27.05.2009 Bulletin 2009/22**

(62) Document number(s) of the earlier application(s) in accordance with Art. 76 EPC:
**98308341.1 / 0 910 119**

(73) Proprietor: **Texas Instruments Incorporated
Dallas, Texas 75251 (US)**

(72) Inventors:
 • **Lin, Boyang
 Richardson, TX 75081 (US)**

 • **Hwang, Ming
 Dallas, TX 75248 (US)**
 • **Niuya, Takayuki
 Tsukuba 305-00 (JP)**
 • **Park, Song C.
 Plano, TX 75025 (US)**

(74) Representative: **Zeller, Andreas et al
Texas Instruments Deutschland GmbH
Haggertystraße 1
85356 Freising (DE)**

(56) References cited:
 **EP-A- 0 671 761     JP-A- 7 066 408
 US-A- 4 505 028**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention pertains to semiconductor devices, and more specifically, to a method for oxidizing or reoxidizing a structure during the fabrication of a semiconductor device.

BACKGROUND OF THE INVENTION

As device dimensions continue to decrease to achieve higher density and performance, there is an increasing demand for highly conductive gate structures, interconnects, and electrodes for metal on silicon (MOS) devices. The polycrystalline silicon ("poly" or "polysilicon") used for these purposes in conventional processes has several limitations, due mainly to its higher resistivity.

Recently, various metal silicides have been considered because they have a conductivity which is higher than that of polysilicon by about an order of magnitude. However, future devices with very high integration densities will, most likely, need to be fabricated with higher conductivity materials for gate structures and interconnects. Therefore, either all metal structures will need to be formed or structures which are comprised of polysilicon and a refractory metal (such as tungsten, molybdenum, cobalt and/or titanium).

With regards to the formation of a gate structure, a thermal oxidation step is needed after the gate patterning, especially for memory devices. This oxidation step is needed to remove damage caused by the patterning and etching of the gate structure (primarily at the gate edges) by reactive ion etching (RIE) and to thicken the gate oxide on the edge so as to improve its reliability and reduce sharp corners at the lower edges of the conductive gate structure. If a polysilicon and tungsten gate structure is used, this oxidation step may create problems because tungsten easily oxidizes at temperatures greater than around 350°C in an oxygen ambient.

A solution to this problem involves using $H_2$ and $H_2O$ to oxidize any existing silicon or silicon oxide surfaces while leaving any tungsten surfaces unoxidized. *See* K. Nakajima, et al., Poly-metal Gate Process --- Ultrathin WSiN Barrier Layer Impermeable to Oxidant In-diffusion during Si Selective Oxidation, CONFERENCE PROCEEDINGS ULSI XI, 1996 MATERIALS RESEARCH SOCIETY 317-323 (1996). A problem with this approach is that a very small amount of water can be used and it is extremely difficult to controllably introduce such small amounts of water in large scale production of semiconductor devices.

SUMMARY OF THE INVENTION

The selective oxidation method disclosed herein involves the oxidation of one material ($M_1$) without substantially oxidizing another material ($M_2$). The chemical reactions for the oxidation of $M_1$ and $M_2$ are (using $O_2$ as the oxidizer):

$$2M_1 + O_2 \rightarrow 2M_1O + E_1 \qquad (1)$$

$$2M_2 + O_2 \rightarrow 2M_2O + E_2 \qquad (2)$$

where $E_1$ and $E_2$ are the enthalpies of formation for reactions (1) and (2), respectively. In order to achieve this selective oxidation, a combination of an oxidizer, preferably $O_2$, and a reducer ,preferably $H_2$, are utilized. The minimum requirement for the successful selective oxidation of $M_1$ while not appreciably oxidizing $M_2$ is that reaction (1) is favored as compared to reaction (2). In other words, $E_1$ is less than $E_2$. In the case where $M_1$ represents silicon, polycrystalline silicon, or amorphous silicon and $M_2$ represents tungsten,

$$Si + O_2 \rightarrow SiO_2 - 911 \text{ kJ/mol} \qquad (3)$$

$$(2/3)W + O_2 \rightarrow (2/3)WO_3 \text{ -562 kJ/mol} \qquad (4)$$

Hence, since $E_1$ is less than $E_2$ (-911 kJ/mol versus -562 kJ/mol), the silicon of reaction (3) will oxidize much more readily than the tungsten of reaction (4).

A method of oxidizing or reoxidizing a structure during the fabrication of semiconductor device (100) is provided. The structure comprises an oxide insulating layer (104) formed over a semiconductor substrate (102), a silicon-containing structure (108) formed on said oxide insulating layer, a metal nitride structure (110) formed on said silicon-containing structure, a metal structure (112) formed on the metal nitride structure, and a nitride structure (114) formed on the metal structure. The method comprises oxidizing, in a semiconductor processing chamber, a portion of said oxide insulating layer (104) and said silicon-containing structure (108) while leaving said metal nitride structure (110) and said metal structure (112) substantially unoxidized by introducing $O_2$ and $H_2$ in the semiconductor processing chamber in a reaction. The reaction between said $O_2$ and $H_2$ does not increase the pressure in the processing chamber beyond a predetermined safe level.

The semiconductor device is, preferably, selected from a group of semiconductor devices consisting of: a transistor, a logic device, a digital signal processor, a microprocessor, or any combination thereof.

Preferably, the oxidizing step is performed by providing around 12% $O_2$ and $H_2$ into the semiconductor processing chamber, and wherein the temperature within the processing chamber is around 1000°C and the pressure is around 13.3 kPa (100 Torr). Further preferred embodiments are as set forth in the appended claims.

BRIEF DESCRIPTION OF THE DRAWINGS

The present invention will now be further described, by way of example, with reference to the accompanying drawings in which:

FIGURE 1 is cross-sectional view of a device formed using a preferred method of fabrication;
FIGURE 2 is a TEM photograph of devices formed using the method of Figure 1; and
FIGURE 3 is a graph illustrating the sheet resistivity of a Tungsten layer.

DETAILED DESCRIPTION OF THE DRAWINGS

A method of oxidizing selective materials such as silicon (single crystal, polycrystalline, or amorphous silicon) without appreciably oxidizing any other materials (such as a tungsten or tungsten nitride structure) is disclosed herein. In one embodiment the oxidation is performed by introducing hydrogen gas and oxygen gas into a chamber where the semiconductor wafer resides and heating the wafer and/or the chamber. Note, however, that the introduction of hydrogen gas along with oxygen gas can be very volatile.

In order to safely oxidize the desired structure while leaving other structures (preferably the refractory metals) unoxidized using oxygen and hydrogen gases, the system pressure should not exceed its safety limit in the presence of the following reaction

$$2H_2 + O_2 \rightarrow 2 H_2O + E \qquad (5)$$

where E is the enthalpy generated by this reaction.

If the system/chamber is first filled with $H_2$ and $O_2$ before reaction (5) takes place, then the final pressure of the system is given by:

$$P \; = \; P_0 \; * \; [1 \; + \; (T/T_0)] \qquad\qquad (1)$$

where T = E/(heat capacitance of the resulting gas system), P is the ending pressure, $P_0$ is the starting pressure of the system, $T_0$ is the starting temperature, and the heat capacitance is a function of the $O_2$ to $H_2$ ratio (and assuming it is independent of the temperature). For example, starting at 500°C with a constant volume mix of $O_2$ in $H_2$ (ratio of 1:10) and an initial pressure of 200 Torr (1 Torr = 133 Pa), the final pressure of the system (using equation (1)) is about 600 Torr which is less than the pressure of the atmosphere. Therefore, this process should be safe.

If reaction (5) occurs as $H_2$ and $O_2$ are entered into the system, then the reaction occurs in only part of the volume of the chamber. By doing this, the safety of the process is improved and the process window can be enlarged because the reaction occurs in only a portion of the total volume of the process chamber thereby leaving the rest of the volume available for expansion. In this case, reaction (5) occurs continuously as the gases enter into the chamber instead of filling the entire chamber with the gases before ignition of the gases.

A variation of this approach is to start the reaction at a lower pressure and increase the pressure once the reaction starts. Another variation involves starting the reaction at a lower concentration of one gas (such as $O_2$) and increasing the concentration once the reaction starts.

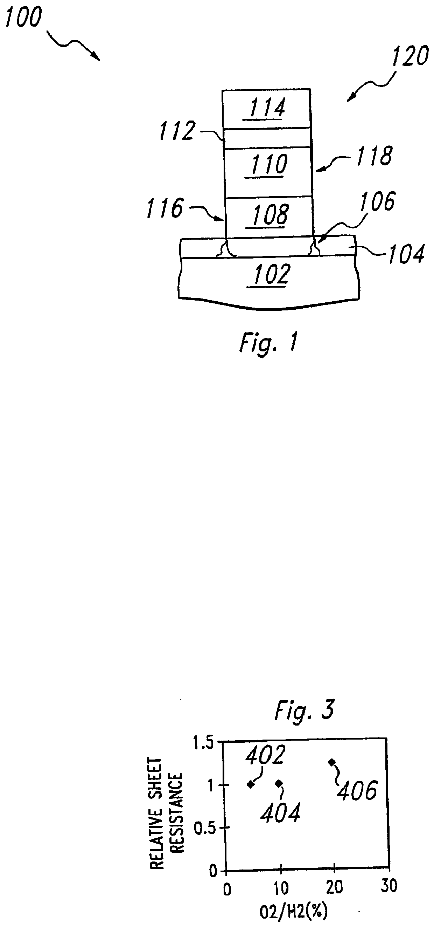

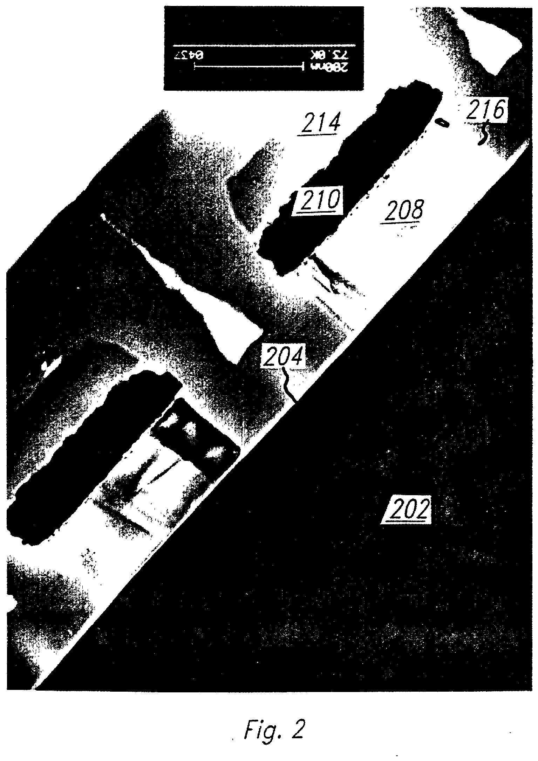

FIGUREs 1 and 2 illustrate a transistor formed using such a method. After gate insulating layer 104 an oxide layer -- preferably $SiO_2$) is formed, a semiconductive layer (preferably in-situ doped, ex-situ doped, or undoped polysilicon) is formed (preferably deposited by chemical vapor deposition). Next, a metal layer is formed (preferably deposited). Preferably, the metal layer is comprised of a metal from the group consisting of tungsten, cobalt, aluminum, or titanium formed over a nitride layer of the metal and nitrogen -- preferably tungsten nitride). This is followed by the formation of a nitride layer (preferably comprised of silicon and nitride - more preferably $Si_4N_3$).

Next, these layers are etched to form gate structure 120 (preferably comprised of polysilicon structure 108, tungsten nitride structure 110, tungsten structure 112, and silicon nitride structure 114). Preferably, this etch step is performed by reactive ion etch (RIE) but it can be accomplished using any standard processing step. One drawback to this etch step, especially when RIE is used, is that it may degrade the gate dielectric at locations 106. If left untreated, this may increase the leakage of the device or may lower the gate oxide integrity (GOI) thereby rendering the device non-functional or damaged. Using conventional oxidation methods, the damaged portions of gate insulating layer 104 are reoxided along with the oxidation of surfaces 116 of polysilicon structure 108 and surfaces 118 of metal structure 110 and 112. In fact, it may even entirely oxidize metal structures 110 and 112. This will severely degrade the device because the conductivity of the resulting structure (including layers 110 and 112) may greatly decrease due to the oxidation of the metal (especially where the metal is tungsten). Oxidation of metal structures 110 and 112 may also cause peeling. The method disclosed herein allows for the reoxidation of layer 104 and the oxidation of silicon-containing structure 108 while leaving metal structure 112 (preferably comprised of W, Ti, Co, Cu, or Al) and metal-nitride structure 110 (preferably comprised of a nitride of a metal such as W, Ti, Co, Cu, or Al - more preferably tungsten nitride) substantially unoxidized. This is shown in FIGURE 2 where region 208 is equivalent to region 108, region 210 is equivalent to regions 110 and 112, region 214 is equivalent to region 114 and region 216 illustrates the formed oxide regions on the side of region 208.

In the preferred method of fabrication, this oxidation step is accomplished by providing around 12% $O_2$ and $H_2$ into a chamber in which the wafer is provided. The pressure within the chamber is preferably around 13.3 kPa and the temperature is around 1000°C. Using this embodiment for around 60 to 80 seconds (preferably 70 seconds) will result in around 3 nm of oxide to be formed on bare silicon and thin silicon oxide, and it will result in around 6 to 10 nm of oxide to be grown on polysilicon structures. While these specific conditions are preferred, the temperature, pressure, time, and amount of oxygen versus that of hydrogen can be changed so as to grow more or less of an oxide film so long as oxidation of the silicon or silicon oxide structure is accomplished while not substantially oxidizing the metal or metal nitride structures.

Preferably, this method of fabrication may be implemented to selectively oxidize silicon structures in the presence of tungsten under the following conditions: the ambient temperature is between 300 and 1200°C; the pressure is around 133 Pa to 10 atmospheric pressure; the oxidizer to reducer ratio i.e. $O_2$ to $H_2$ ratio, is around 0.1% to 99.9%; and the duration is around 1 second to 10 hours.

FIGURE 4 is a graph illustrating relative sheet resistivity of a tungsten layer which is approximately 60 nm thick and is subjected to the oxidation step of the method disclosed herein versus the percentage of $O_2/H_2$ mixture. The pressure is around 13.3 kPa at around 1000°C. Points 402 and 404 illustrate that the sheet resistivity of a tungsten layer subjected to an oxidation step of the method disclosed herein, where the $O_2/H_2$ mixture is 10% or less, has the same sheet resistivity as a tungsten layer which has not been subjected to an oxidation step. Point 406 illustrates that the sheet resistivity of a tungsten layer subjected to an oxidation step of the instant invention, where the $O_2/H_2$ mixture is around 20%, has a sheet resistivity around 20% higher than that of an untreated tungsten layer.

**Claims**

1. A method of oxidizing or reoxidizing a gate structure (120) formed by etching during the fabrication of semiconductor device (100), said structure comprising an oxide insulating layer (104) formed over a semiconductor substrate (102), a silicon-containing structure (108) formed on said oxide insulating layer, a metal nitride structure (110) formed on said silicon-containing structure, a metal structure (112) formed on the metal nitride structure, and a nitride structure (114) formed on the metal structure, the method comprising the step of:

   re-oxidizing, in a semiconductor processing chamber, a damaged portion (106) of said oxide insulating layer (104) and oxidizing said silicon-containing structure (108) while leaving said metal nitride structure (110) and said metal structure (112) substantially unoxidized by introducing $O_2$ and $H_2$ in the semiconductor processing chamber in a reaction, such that the reaction between said $O_2$ and $H_2$ does not increase the pressure in the processing chamber beyond a predetermined safe level.

2. The method of Claim 1, wherein said semiconductor device is one selected from a group of semiconductor devices consisting of: a transistor, a logic device, a digital signal processor, a microprocessor, or any combination thereof.

3. The method of Claim 1 or 2 wherein
said metal nitride structure (110) comprises a nitride of a metal selected from a group consisting of: W, Ti, Co, Cu, or Al; and
said metal structure (112) comprises a material selected from a group consisting of: W, Ti, Co, Cu, or Al.

4. The method of any of Claims 1 to 3 wherein the metal nitride structure (110) comprises a material consisting of tungsten nitride, and the metal structure (112) comprises a material consisting of tungsten.

5. The method of any of Claims 1 to 4 wherein the oxidizing step is performed by providing around 12% $O_2$ and $H_2$ into the semiconductor processing chamber, and wherein the temperature within the processing chamber is around 1000°C and the pressure is around 13.3 kPa.

6. The method of any of Claims 1 to 4 wherein the oxidizing step comprises starting the reaction as $H_2$ and $O_2$ enter the semiconductor processing chamber, whereby the reaction occurs in only part of the volume of the chamber.

7. The method of any of Claims 1 to 4 wherein the oxidizing step further comprises starting the reaction at a lower pressure and increasing the pressure once the reaction has started.

8. The method of any of Claims 1 to 4 wherein the oxidizing step further comprises starting the reaction at a lower concentration of $O_2$ and increasing the concentration once the reaction has started.


**Patentansprüche**

1. Verfahren zum Oxidieren oder Reoxidieren einer Gate-Struktur (120), die durch Ätzen gebildet wird, während der Herstellung einer Halbleitervorrichtung (100), wobei die Struktur eine Oxidisolierschicht (104), die über einem Halbleitersubstrat (102) ausgebildet ist, eine Silicium enthaltende Struktur (108), die auf der Oxidisolierschicht ausgebildet ist, eine Metallnitridstruktur (110), die auf der Silicium enthaltenden Struktur ausgebildet ist, eine Metallstruktur (112), die auf der Metallnitridstruktur ausgebildet ist, und eine Nitridstruktur (114), die auf der Metallstruktur ausgebildet ist, umfasst,
wobei das Verfahren folgenden Schritt umfasst:

   Reoxidieren eines beschädigten Abschnitts (106) der Oxidisolierschicht (104) in einer Halbleiterverarbeitungskammer und
   Oxidieren der Silicium enthaltenden Struktur (108), während die Metallnitridstruktur (110) und die Metallstruktur (112) im Wesentlichen nicht oxidiert bleiben, durch Einleiten von $O_2$ und $H_2$ in die Halbleiterverarbeitungskammer bei einer Reaktion, so dass die Reaktion zwischen dem $O_2$ und $H_2$ den Druck in der Verarbeitungskammer nicht über einen vorgegebenen sicheren Pegel erhöht.

2. Verfahren nach Anspruch 1, wobei die Halbleitervorrichtung aus einer Gruppe von Halbleitervorrichtungen ausgewählt wird, die aus einem Transistor, einer Logikvorrichtung, einem Digitalsignalprozessor, einem Mikroprozessor oder einer Kombination davon besteht.

3. Verfahren nach Anspruch 1 oder 2, wobei
die Metallnitridstruktur (110) ein Nitrid eines Metalls umfasst, das aus einer Gruppe ausgewählt wird, die aus W, Ti, Co, Cu oder Al besteht, und
die Metallstruktur (112) ein Material umfasst, das aus einer Gruppe ausgewählt wird, die aus W, Ti, Co, Cu oder Al besteht.

4. Verfahren nach einem der Ansprüche 1 bis 3, wobei die Metallnitridstruktur (110) ein Material umfasst, das aus Wolframnitrid besteht, und die Metallstruktur (112) ein Material umfasst, das aus Wolfram besteht.

5. Verfahren nach einem der Ansprüche 1 bis 4, wobei der Oxidierschritt durch Bereitstellen von etwa 12 % $O_2$ und $H_2$ in der Halbleiterverarbeitungskammer ausgeführt wird und wobei die Temperatur innerhalb der Verarbeitungskammer um 1000 °C liegt und der Druck um 13,3 kPa liegt.

6. Verfahren nach einem der Ansprüche 1 bis 4, wobei beim Oxidierschritt die Reaktion eingeleitet wird, wenn $H_2$ und $O_2$ in die Halbleiterverarbeitungskammer eintreten, wodurch die Reaktion nur in einem Teil des Volumens der Kammer geschieht.

7. Verfahren nach einem der Ansprüche 1 bis 4, wobei beim Oxidierschritt ferner die Reaktion bei einem niedrigeren Druck eingeleitet wird und der Druck erhöht wird, sobald die Reaktion begonnen hat.

**8.** Verfahren nach einem der Ansprüche 1 bis 4, wobei beim Oxidierschritt ferner die Reaktion bei einer niedrigeren $O_2$-Konzentration eingeleitet wird und die Konzentration erhöht wird, sobald die Reaktion begonnen hat.

## Revendications

**1.** Procédé d'oxydation ou réoxydation d'une structure de grille (120) formée par gravure pendant la fabrication d'un dispositif semi-conducteur (100), ladite structure comprenant une couche d'oxyde isolante (104) formée par-dessus un substrat semi-conducteur (102), une structure contenant du silicium (108) formée sur ladite couche d'oxyde isolante, une structure de nitrure métallique (110) formée sur ladite structure contenant du silicium, une structure métallique (112) formée sur la structure de nitrure métallique, et une structure de nitrure (114) formée sur la structure métallique,
le procédé comprenant l'étape consistant à :

réoxyder, dans une chambre de traitement de semi-conducteurs, une partie endommagée (106) de ladite couche d'oxyde isolante (104) et oxyder ladite structure contenant du silicium (108) tout en laissant ladite structure de nitrure métallique (110) et ladite structure métallique (112) sensiblement non oxydées en introduisant $O_2$ et $H_2$ dans la chambre de traitement de semi-conducteurs dans une réaction, de telle sorte que la réaction entre lesdits $O_2$ et $H_2$ n'augmente pas la pression dans la chambre de traitement au-delà d'un niveau sûr prédéterminé.

**2.** Procédé de la revendication 1, dans lequel ledit dispositif semi-conducteur est un dispositif choisi dans un groupe de dispositifs semi-conducteurs constitué par : un transistor, un dispositif logique, un processeur de signal numérique, un microprocesseur, ou toute combinaison de ceux-ci.

**3.** Procédé de la revendication 1 ou 2 dans lequel
ladite structure de nitrure métallique (110) comprend un nitrure d'un métal choisi dans un groupe constitué par : W, Ti, Co, Cu, ou Al ; et
ladite structure métallique (112) comprend un matériau choisi dans un groupe constitué par : W, Ti, Co, Cu, ou Al.

**4.** Procédé de l'une quelconque des revendications 1 à 3 dans lequel la structure de nitrure métallique (110) comprend un matériau consistant en du nitrure de tungstène, et la structure métallique (112) comprend un matériau consistant en du tungstène.

**5.** Procédé de l'une quelconque des revendications 1 à 4 dans lequel l'étape d'oxydation est effectuée en introduisant environ 12 % d'$O_2$ et $H_2$ dans la chambre de traitement de semi-conducteurs, et dans lequel la température à l'intérieur de la chambre de traitement est d'environ 1000 °C et la pression est d'environ 13,3 kPa.

**6.** Procédé de l'une quelconque des revendications 1 à 4 dans lequel l'étape d'oxydation comprend le démarrage de la réaction lorsque $H_2$ et $O_2$ pénètrent dans la chambre de traitement de semi-conducteurs, la réaction se produisant ainsi uniquement dans une partie du volume de la chambre.

**7.** Procédé de l'une quelconque des revendications 1 à 4 dans lequel l'étape d'oxydation comprend en outre le démarrage de la réaction à une pression inférieure et l'augmentation de la pression une fois que la réaction a démarré.

**8.** Procédé de l'une quelconque des revendications 1 à 4 dans lequel l'étape d'oxydation comprend en outre le démarrage de la réaction à une concentration d'$O_2$ inférieure et l'augmentation de la concentration une fois que la réaction a démarré.

*100*

*120*

*112*

*114*

*118*

*110*

*116*

*108*

*106*

*104*

*102*

*Fig. 1*

*Fig. 3*

*402*

*404*

*406*

RELATIVE SHEET RESISTANCE

1.5

1

0.5

0

0    10    20    30

O2/H2(%)

Fig. 2

EP 2 063 464 B1

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **K. NAKAJIMA et al.** Poly-metal Gate Process --- Ultrathin WSiN Barrier Layer Impermeable to Oxidant In-diffusion during Si Selective Oxidation. *CONFERENCE PROCEEDINGS ULSI XI, 1996 MATERIALS RESEARCH SOCIETY,* 1996, 317-323